# EUROPEAN PATENT APPLICATION

(11) **EP 1 596 187 A1**
(43) Date of publication of application: **16.11.2005**
(21) Application number: 04709726.6
(22) Date of filing: 10.02.2004
(51) Int. Cl.: G01N 24/08

(54) **METHOD OF NMR MEASUREMENT OF PROTEIN**

(30) Priority: 10.02.2003 JP 2003032381
(71) Applicant: MITSUBISHI CHEMICAL CORPORATION, Tokyo 108-0014 (JP); Endou, Yaete, Matsuyama-shi Ehime 7918016 (JP)
(72) Inventor: ENDOU, Yaeta, 7918016 (JP); KOHNO, Toshiyuki c/o Mitsubishi Kagaku Institute, Tokyo1948511 (JP); MORITA, Hayato 205, Raibutaun Takasago, Ehime, 790-0822 (JP)
(74) Representative: Alcock, David
(86) International application number: PCT/JP2004/001420
(87) International publication number: WO 2004/070371

(57) **Abstract**

An object of the present invention is to provide a means for highly efficiently or quickly evaluating or determining the three-dimensional structure of a protein by conducting multidimensional multinuclear NMR measurement without performing a step of separating and purifying the synthesized labeled protein from other labeled proteins. The present invention provides a method for analyzing proteins, which comprises: synthesizing a protein of interest under conditions in which 90% or more of the synthesized labeled proteins constitute the protein of interest, when proteins are synthesized using a nucleic acid encoding the protein of interest as a template and also using substrate amino acids, a part or all of which have been labeled in such a way that NMR measurement is possible; and performing the NMR measurement using the above-described labeled proteins.

## Description

### TECHNICAL FIELD

The present invention relates to: a method for analyzing a protein, which comprises synthesizing a protein of interest as a labeled protein and measuring NMR thereof; and a method for analyzing the folding of the above protein.

### BACKGROUND ART

A method for determining the three-dimensional structure of a protein using NMR or X-ray has widely been utilized. Either the use of NMR or X-ray requires a high purity protein of the order of several tens of mg. In order to analyze the three-dimensional structure of a protein of interest using NMR or X-ray, it is necessary to prepare a large amount of the protein of interest using a recombinant protein-synthesizing system such as *Escherichia coli* and to highly purify it. Moreover, the above method requires the conditions that a protein of interest has a regular three-dimensional structure and that the protein is synthesized to have a single three-dimensional structure without forming an aggregate.

A method for evaluating the three-dimensional structure of a protein, which comprises: labeling a nitrogen atom contained in the protein with ¹⁵N, which is a stable isotope enabling NMR measurement; measuring the ¹H-¹⁵N HSQC spectrum of the protein of interest by the NMR HSQC (heteronuclear single quantum coherence) method; and analyzing based on the number of the obtained signals or a dispersion level thereof, whether the protein of interest has a regular three-dimensional structure or it does not form an aggregate, has been known (Montelione G. T. et al., 2000 Nature Struct. Biol. 7 Suppl: 982-985). According to such a method, the availability of preparation of a ¹³C/¹⁵N double-labeled protein used for determination of the three-dimensional structure of the protein of interest by NMR, or the availability of crystallization of a protein used for determination of the three-dimensional structure by X-ray analysis, can be examined prior to conduction of these experiments.

### DISCLOSURE OF THE INVENTION

In order to identify the folding of a protein by the conventional NMR measurement, it is necessary that such a protein of interest which is labeled in such a way that NMR measurement is possible be synthesized in a large amount using nucleic acid encoding the protein of interest. However, when such a labeled protein is synthesized by the protein synthesis method using ordinary living cells or the cell-free protein synthesis method using *Escherichia coli* or the like, labeled proteins other than the protein of interest are also synthesized. Thus, in order to measure the ¹H-¹⁵N HSQC spectrum, a step of purifying the protein of interest from other labeled proteins has been essential. For example, when a protein of interest labeled with ¹⁵N is synthesized in a biosynthesis system such as *Escherichia coli*, yeast, or cultured cells, proteins other than the protein of interest in cells are all labeled. Hence, unless the protein of interest is not separated by purification, signals from many types of proteins are simultaneously measured, and thus the signals cannot be evaluated. In addition, if such a ¹⁵N-labeled protein of interest were synthesized in a cell-free protein synthesis system derived from *Escherichia coli,* in principle, only the protein of interest would be labeled with ¹⁵N. However, in reality, such a problem as the contamination of other mRNAs is inevitable. Proteins other than the protein of interest are labeled (hereinafter, such proteins may be referred to as "non-specifically labeled proteins" at times), and signals derived from non-specifically labeled proteins may be measured. Moreover, since a cell-free protein synthesis system derived from *Escherichia coli* contains proteases, it has been problematic in that a protein of interest is decomposed during the NMR measurement that is performed for a long period of time at a temperature higher than room temperature, and in that correct signals cannot be obtained.

A step of separating and purifying a protein of interest from labeled proteins synthesized by a common synthesis method is complicated. In addition, it also has a problem regarding a synthesis efficiency of the protein of interest. Thus, a means for solving the aforementioned problems of the conventional NMR techniques regarding preparation of labeled proteins, that is, a means for highly efficiently or quickly evaluating or determining the three-dimensional structure of a protein by conducting multidimensional multinuclear NMR measurement without performing a step of separating and purifying the synthesized labeled protein of interest from other labeled proteins, has been desired.

The present inventors have synthesized a yeast ubiquitin protein or the like in a cell-free protein synthesis system derived from a wheat germ extract, using ¹⁵N-labeled amino acids. Thereafter, the inventors have subjected the synthesized labeled proteins to NMR analysis by the HSQC method, without separating and purifying a protein of interest from the synthesized labeled proteins. As a result, they have found that the same spectrum as in the case of performing NMR analysis by the HSQC method after separating and purifying a protein of interest from the above proteins synthesized in living cells of *Escherichia coli,* can be obtained. They have also found that noise spectrum, which is generated when the same above proteins are synthesized from a cell extract of *Escherichia coli* and the proteins are then subjected to NMR analysis without separating and purifying a protein of interest therefrom, cannot be observed in the above method. The present invention has been completed based on these findings.

That is to say, the present invention provides a method for analyzing proteins, which comprises: synthesizing a protein of interest under conditions in which 90% or more of the synthesized labeled proteins constitute the protein of interest, when proteins are synthesized using a nucleic acid encoding the protein of interest as a template and also using substrate amino acids, a part or all of which have been labeled in such a way that NMR measurement is possible; and performing the NMR measurement using the above-described labeled proteins.

Preferably, the method for synthesizing the protein of interest is a method using a cell-free protein synthesis system derived from a wheat germ extract, wherein a step of separating the protein of interest from the synthesized labeled proteins is not performed.

Preferably, in the method for synthesizing the protein of interest, among substrate amino acids used, 3 or more types of amino acids are labeled in such a way that NMR measurement is possible.

Preferably, the wheat germ extract is extracted from the wheat germ that has been separated such that it does not contain albumen.

Preferably, the wheat germ extract has a DNA content of 230 µg/ml or less, when the optical density (O.D.) at 260 nm (A260) is 90.

Preferably, the wheat germ extract has a total amount of total fatty acids (palmitic acid, oleic acid, and linolic acid) of 0.03 g or less/100 g, when the optical density (O.D.) at 260 nm (A260) is 90.

Preferably, the wheat germ extract has a DNA content of 230 µg/ml or less and a total amount of total fatty acids of 0.03 g or less/100 g, when the optical density (O.D.) at 260 nm (A260) is 90.

Preferably, the method for analyzing a protein is a method for identifying the folding of a protein.

Preferably, the method for identifying the folding of a protein is a method for determining that a synthesized protein has a regular three-dimensional structure.

Preferably, the method for identifying whether or not a protein has a regular three-dimensional structure is a method for determining that a protein has a regular three-dimensional structure, when the number of signals derived from a main chain in the spectrum obtained by NMR measurement makes up 80% or more of the total number of labeled amino acid residues of the above protein.

Preferably, the method for identifying whether or not a protein has a regular three-dimensional structure is a method for determining that a protein has a regular three-dimensional structure, when chemical shifts of 30% or more of hydrogen atoms of signals derived from a main chain in the spectrum obtained by NMR measurement is out of the range between 8.0 and 8.5 ppm.

Preferably, the method for identifying the folding of a protein is a method for identifying whether or not a protein has a single three-dimensional structure.

Preferably, the method for identifying the folding of a protein is a method for identifying whether or not a protein has a single regular three-dimensional structure.

Preferably, the method for identifying whether or not a protein has a single regular three-dimensional structure is a method for determining that a protein has a single regular three-dimensional structure, when the number of signals derived from a main chain of the spectrum obtained by NMR measurement makes up 80% to 100% or less of the total number of labeled amino acid residues of the above protein.

### BRIEF DESCRIPTION OF THE DRAWINGS

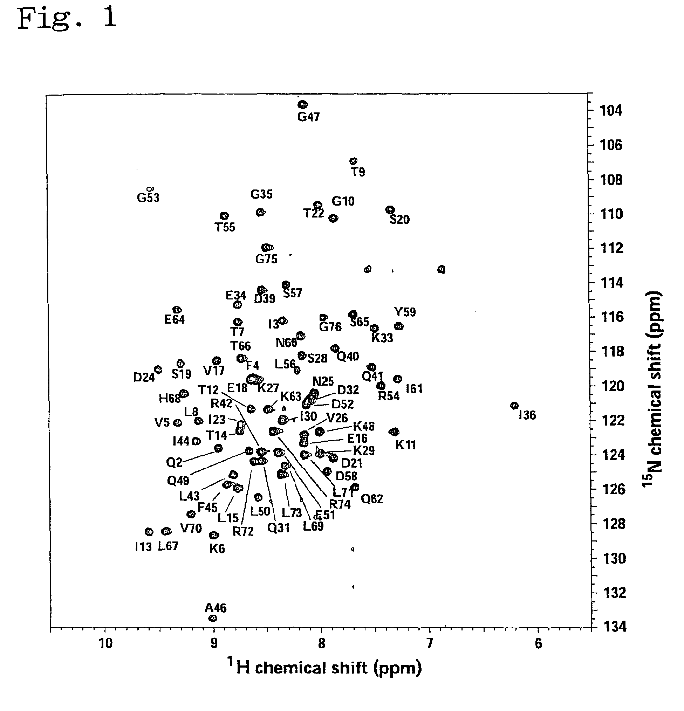

Figure 1 is a view showing the results obtained by synthesizing a ¹⁵N-labeled yeast ubiquitin protein in a cell-free protein synthesis system derived from a wheat germ extract, concentrating the yeast ubiquitin protein without purifying it from other labeled proteins, and exchanging the buffer solution with another one, followed by ¹H-¹⁵N HSQC measurement.

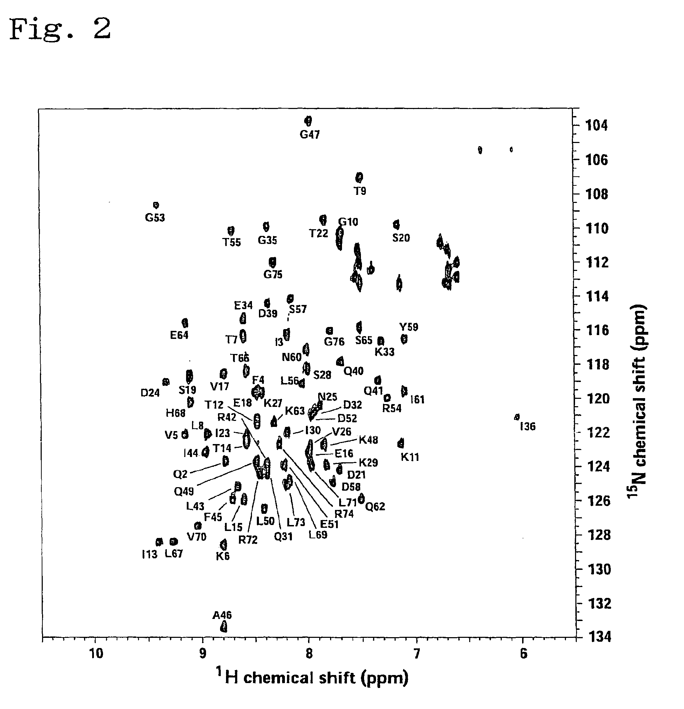

Figure 2 is a view showing the results obtained by the ¹H-¹⁵N HSQC measurement of ¹⁵N-labeled yeast ubiquitin, which has been synthesized in living cells of *Escherichia coli* and then purified. According to protein synthesis using a cell-free protein synthesis system derived from a wheat germ extract, the same ¹H-¹⁵N HSQC spectrum as that in the case of using a separated and purified protein can be obtained, even if a protein of interest is not separated and purified after the synthesis.

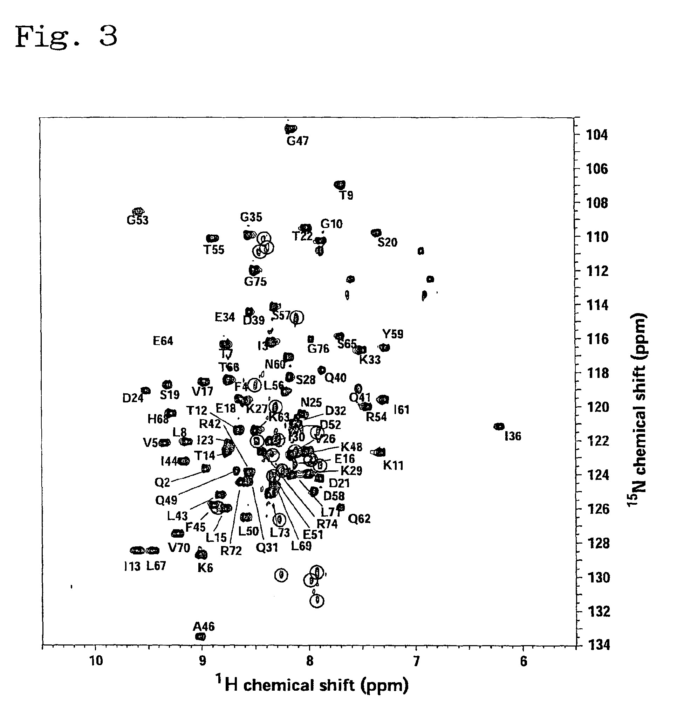

Figure 3 shows the results obtained by synthesizing ¹⁵N-labeled yeast ubiquitin using a cell extract of *Escherichia coli,* concentrating a protein of interest without separating and purifying it from other labeled proteins, and exchanging the buffer solution with another one, followed by the measurement of ¹H-¹⁵N HSQC spectrum. When a labeled protein is synthesized in a cell-free protein synthesis system derived from a cell extract of *Escherichia coli,* since labeled proteins other than the protein of interest are synthesized, signals obtained by the ¹H-¹⁵N HSQC measurement include noise signals.

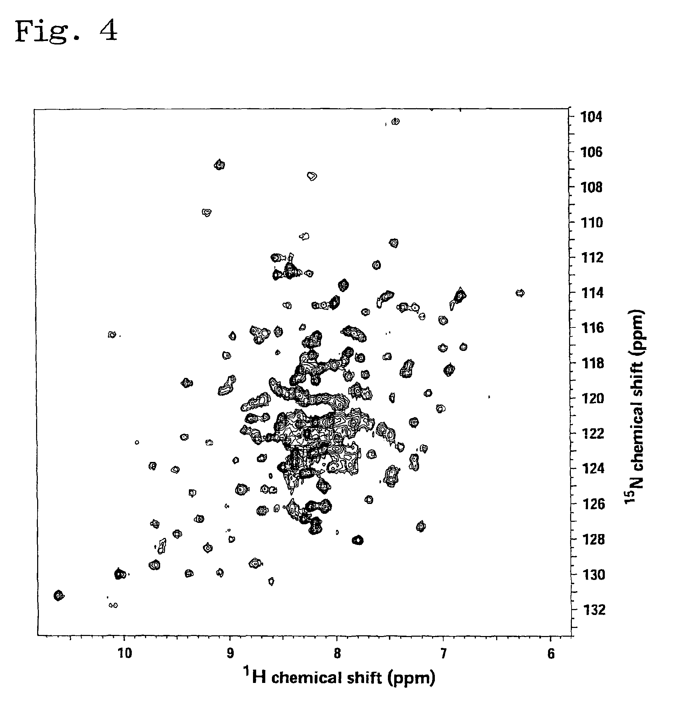

Figure 4 is a view showing the results obtained by synthesizing a ¹⁵N-labeled yeast ubiquitin hydrolase 1 protein in a cell-free protein synthesis system derived from a wheat germ extract, concentrating the yeast ubiquitin hydrolase 1 protein without separating and purifying it from other labeled proteins, and exchanging the buffer solution with another one, followed by ¹H-¹⁵N HSQC measurement.

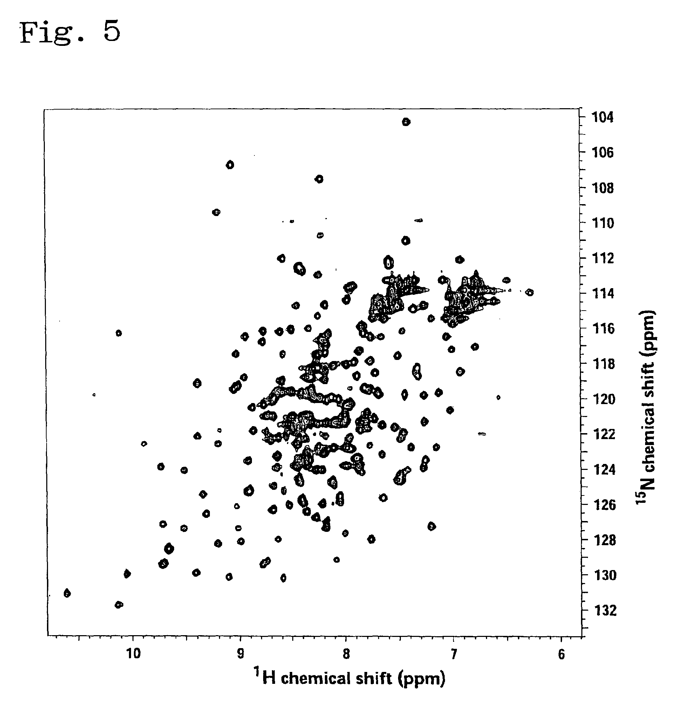

Figure 5 is a view showing the results obtained by the ¹H-¹⁵N HSQC measurement of ¹⁵N-labeled yeast ubiquitin hydrolase 1, which has been synthesized in living cells of *Escherichia coli* and then purified. According to protein synthesis using a cell-free protein synthesis system derived from a wheat germ extract, the same ¹H-¹⁵N HSQC spectrum as that in the case of using a separated and purified protein can be obtained, even if a protein of interest is not separated and purified after the synthesis.

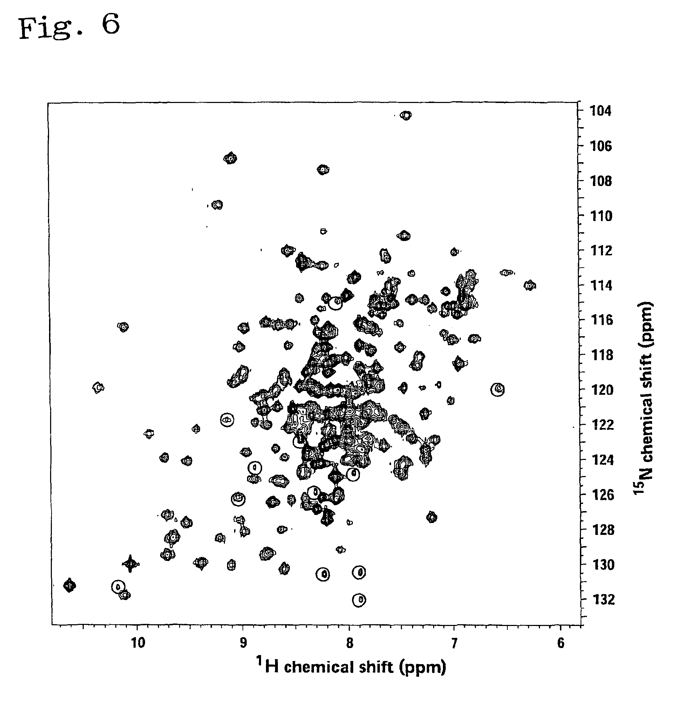

Figure 6 is a view showing the results obtained by synthesizing a ¹⁵N-labeled yeast ubiquitin hydrolase 1 protein in a cell-free protein synthesis system derived from a cell extract of *Escherichia coli,* concentrating the yeast ubiquitin hydrolase 1 protein without separating and purifying it from other labeled proteins, and exchanging the buffer solution with another one, followed by ¹H-¹⁵N HSQC measurement. In the case of using the yeast ubiquitin hydrolase 1 protein as a protein of interest as well, when a labeled protein is synthesized in a cell-free protein synthesis system derived from a cell extract of *Escherichia coli,* since labeled proteins other than the protein of interest are synthesized, signals obtained by the ¹H-¹⁵N HSQC measurement include noise signals.

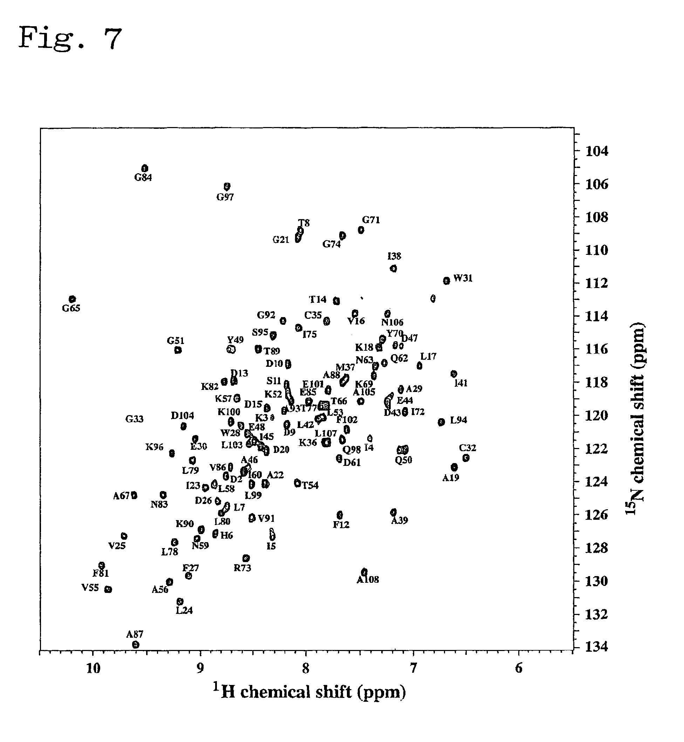

Figure 7 is a view showing the results obtained by synthesizing a ¹⁵N-labeled *Escherichia coli* thioredoxin protein in a wheat germ cell-free protein synthesis system, concentrating the synthesized protein without purification, and exchanging the buffer solution with another one, followed by the measurement of ¹H-¹⁵N HSQC spectrum.

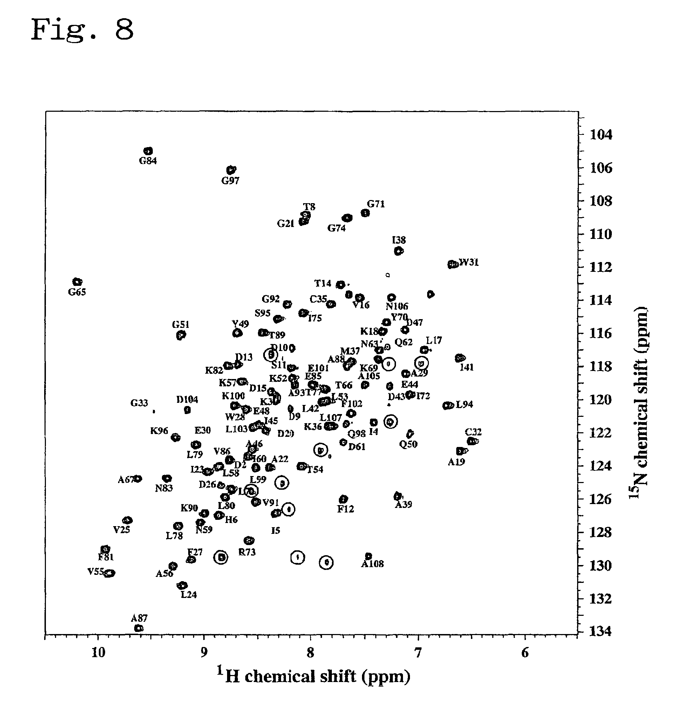

Figure 8 is a view showing the results obtained by synthesizing a ¹⁵N-labeled *Escherichia coli* thioredoxin protein using a cell extract of *Escherichia coli,* concentrating the synthesized protein without purification, and exchanging the buffer solution with another one, followed by the measurement of ¹H-¹⁵N HSQC spectrum.

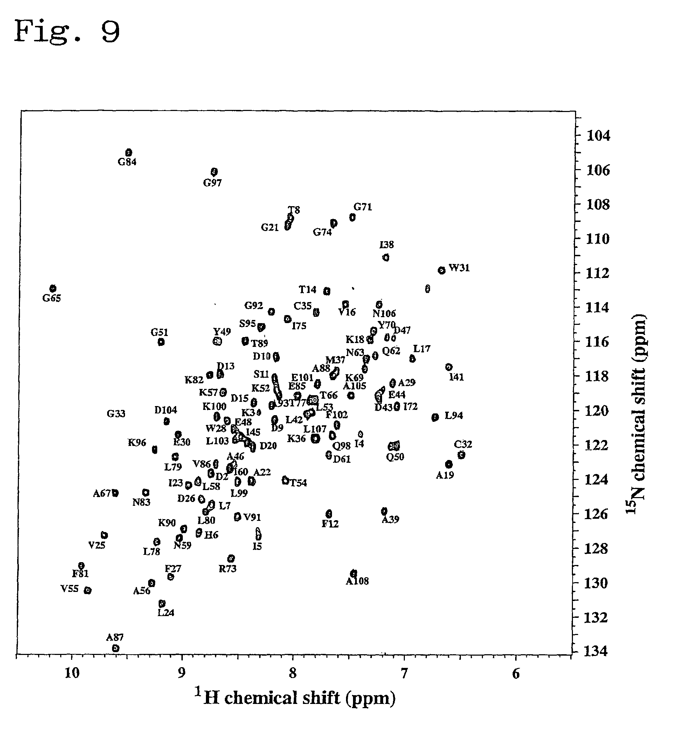

Figure 9 is a view showing the results obtained by synthesizing a ¹⁵N-labeled *Escherichia coli* thioredoxin protein in a wheat germ cell-free protein synthesis system, concentrating the synthesized protein without purification, and exchanging the buffer solution with another one, followed by the measurement of ¹H-¹⁵N HSQC spectrum.

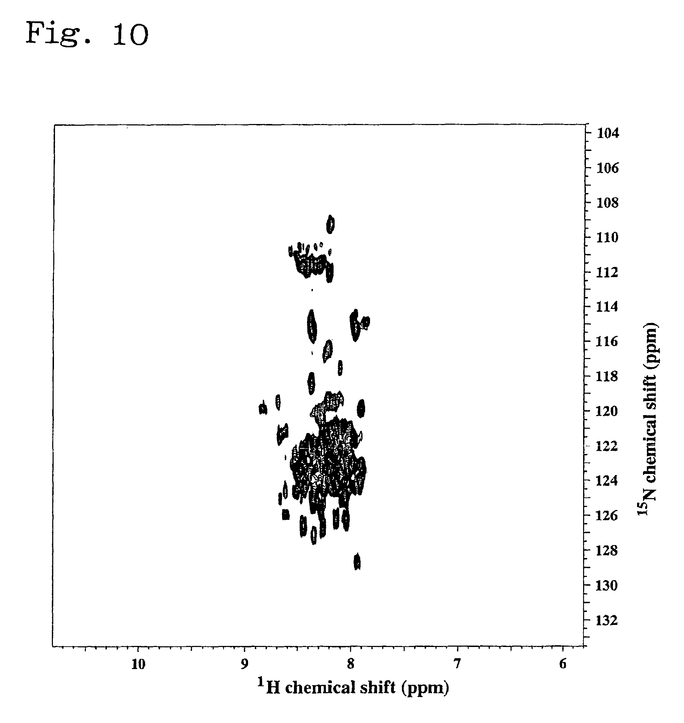

Figure 10 is a view showing the results obtained by synthesizing a ¹⁵N-labeled human mcm4 protein in a wheat germ cell-free protein synthesis system, concentrating the synthesized protein without purification, and exchanging the buffer solution with a fresh one, followed by the measurement of ¹H-¹⁵N HSQC spectrum.

### BEST MODE FOR CARRYING OUT THE INVENTION

The terms used in the present specification have the following meanings, unless otherwise specified.

The term "a method for analyzing proteins" is used to mean a method, which comprises: synthesizing a protein of interest under conditions in which 90% or more of the synthesized labeled proteins constitute the protein of interest, when proteins are synthesized using a nucleic acid encoding the protein of interest as a template and also using substrate amino acids, a part or all of which have been labeled in such a way that NMR measurement is possible; and performing the NMR measurement using the above-described labeled proteins. The analysis of proteins by this method includes all analysis that can be carried out on proteins by NMR measurement. An example of such analyzed contents may include identification of the folding of a protein. Preferred examples of a method for identifying the folding of a protein may include: a method for identifying whether or not a protein has a regular three-dimensional structure; a method for identifying whether or not a protein has a single three-dimensional structure; and a method for identifying whether or not a protein has a single regular three-dimensional structure.

The term "a protein of interest" is used to mean all proteins that can be targets for the method for analyzing proteins of the present invention. The term "protein" is used in the present specification to mean the broadest range of proteins. Examples of such a protein may include a polypeptide with a length that is enough to have a three-dimensional structure; a partial polypeptide of a protein existing in a living body; and a protein comprised of identical or different multiple polypeptide chains (that is, a protein composed of multiple subunits).

The term "nucleic acid encoding a protein of interest" is used to mean not only nucleic acid comprising an ORF region encoding the protein of interest, but also nucleic acid comprising a region having a nucleotide sequence, which is able to produce the protein of interest when it is used as a template in a protein synthesis system suitable for the method of the present invention. These nucleic acids may be DNA, RNA, or a derivative thereof. In the case of using a cell-free protein synthesis system derived from a wheat germ extract which will be described later as a protein synthesis system, a preferred example of such nucleic acid may be RNA, which is obtained by transcribing DNA having at least a nucleotide sequence wherein an SP6 promoter, a translation-activating sequence, or the like are bound to 5'-upstream side of the ORF region, using SP6 RNA polymerase, and then purifying the product by ethanol precipitation. Moreover, RNA wherein a sequence used for termination of transcription or a non-translation region used for stabilization of the RNA is bound to the 3'-downstream side of ORF is also preferably used. In the case of DNA, these nucleic acids may be either circular plasmids or linear. Linear DNA encoding a protein of interest can be prepared by a method using polymerase chain reaction (PCR) (WO2002/18586).

The term "amino acids labeled in such a way that NMR measurement is possible" is used to mean amino acids labeled in such a way that they can be measured by any one of NMR measurement methods used in the present invention, which will be described later. When the ¹H-¹⁵N HSQC measurement method is applied as such an NMR measurement method, amino acids, at least one nitrogen atom in the main chain of which is substituted with ¹⁵N, can be used.

All the substrate amino acids used in the method of the present invention are not necessarily labeled in such a way that NMR measurement is possible (which may be hereinafter referred to as "labeled" at times). It may be adequate that at least 3 types of amino acids be labeled. The method of the present invention brings on greater effects, when a protein is synthesized using more labeled amino acids as substrates.

The term "a labeled protein" is used to mean a protein comprising, as constitutional elements, amino acids labeled in such a way that NMR measurement is possible. A protein that is a labeled protein and also is a protein of interest is referred to as a "labeled protein of interest."

The term "NMR measurement" includes all methods used for common heteronuclear solution NMR. In general, such measurement is carried out in a state where samples are not rotated. Specifically, any of heteronuclear multidimensional NMR measurement methods may be applied. Examples of such a heteronuclear multidimensional NMR measurement method may include HSQC, HMQC, CH-COSY, CBCANH, CBCA(CO)NH, HNCO, HN(CA)CO, HNHA, H(CACO)NH, HCACO, 15N-edited NOESY-HSQC, 13C-edited NOESY-HSQC, 13C/15N-edited HMQC-NOESY-HMQC, 13C/13C-edited HMQC-NOESY-HMQC, 15N/15N-edited HSQC-NOESY-HSQC (Cavanagh W. J. et al., Protein NMR Spectroscopy. Principles and Practice, Academic Press(1996)), HN(CO)CACB, HN(CA)CB, HN(COCA)CB (Yamazaki T. et al., J. Am. Chem. Soc., 116 (1994) 11655-11666), H(CCO)NH, C(CO)NH (Grzesiek S. et al., J. Magn. Reson., B 101 (1993) 114-119), CRIPT, CRINEPT (Riek R. et al., Proc. Natl. Acad. Sci. USA., 96 (1999) 4918-4923), HMBC, HBHA(CBCACO)NH (Evans J. N. S., Biomolecular NMR Spectroscopy. Oxford University Press (1995) 71), INEPT (Morris G. A. et al., J. Am. Chem. Soc., 101 (1979) 760-762), HNCACB (Wittekind M. et al., J. Magn. Reson. B 101 (1993) 201), HN(CO)HB (Grzesiek S. et al., J. Magn. Reson. 96 (1992) 215-222.), HNHB (Archer S. J. et al., J. Magn. Reson., 95 (1991) 636-641), HBHA(CBCA)NH (Wang A.C. et al., J. Magn. Reson., B 105 (1994) 196-198.), HN(CA)HA (Kay L. E. et al., J. Magn. Reson., 98 (1992) 443-450), HCCH-TOCSY (Bax A. et al., J. Magn. Reson., 88 (1990) 425-431), TROSY (Pervushin K. et al., Proc. Natl. Acad. Sci., 94 (1997) 12366-12371), 13C/15N-edited HMQC-NOESY-HSQC (Jerala R. et al., J. Magn. Reson., 108 (1995) 294-298), HN(CA)NH (Ikegami T. et al., J. Magn. Reson., 124 (1997) 214217), and HN(COCA)NH (Grzesiek S. et al., J. Biomo. NMR, 3 (1993) 627-638.), but examples are not limited thereto. Of these, the HSQC method and the HMQC method are preferably used as NMR measurement in the present invention.

The method of the present invention is a method for analyzing proteins, which comprises: synthesizing a protein of interest under conditions in which 90% or more, preferably 93% or more, more preferably 95% or more, further preferably 97% or more, and particularly preferably 99% or more of the synthesized labeled proteins constitute the protein of interest (hereinafter, such conditions may be simply referred to as "conditions" at times), when proteins are synthesized, using a nucleic acid encoding the protein of interest as templates and also using substrate amino acids, a part or all of which have been labeled in such a way that NMR measurement is possible; and performing the NMR measurement using the above-described labeled proteins.

Any method can be applied as a method of synthesizing proteins, as long as it satisfies the aforementioned conditions. A specific example is the use of a cell-free protein synthesis system derived from a wheat germ extract. When the labeled protein of interest is synthesized using the above protein synthesis system, 90% or more, preferably 93% or more, more preferably 95% or more, further preferably 97% or more, and particularly preferably 99% or more of all the labeled proteins synthesized in the above synthesis system constitute the protein of interest. Thus, it becomes unnecessary to perform a step of separating and purifying the protein of interest from the labeled proteins. Accordingly, the use of a cell-free protein synthesis system derived from a wheat germ extract has the effect of significantly enhancing operability.

The term "a cell-free protein synthesis system derived from a wheat germ extract" indicates any type of system, as long as it satisfies the aforementioned conditions. Preferably, systems described below can be used.

A method for producing a wheat germ extract used in the present invention is not particularly limited, as long as the produced wheat germ extract enables the cell-free protein synthesis when template nucleic acid, amino acids, an energy source, or the like are supplied thereto. An extract obtained by separating wheat germ from albumen in a wheat seed, followed by extraction and purification from the wheat germ, can preferably be used as a wheat germ extract in the present invention. Such a wheat germ extract may be prepared from a wheat seed by the following methods, or commercially available products may be used. An example of a commercially available cell extract may be PROTEIOS™ (manufactured by TOYOBO) derived from wheat germ.

As a method for producing a wheat germ extract, methods described in Johnston F. B. et al., Nature, 179, 160-161 (1957), Erickson A. H. et al., (1996) Meth. In Enzymol., 96, 38-50, etc. can be applied. Such a method for producing a wheat germ extract will be described more in detail below.

In the production of a wheat germ extract used in the present invention, first, components other than wheat germ, including albumen as a typical example, are preferably completely eliminated. As a common method of preparing such germ, a mechanical power is first applied to a wheat seed, so as to obtain a mixture comprising germ, crushed albumen fragments, and crushed seed coat fragments, and the crushed albumen fragments and the crushed seed coat fragments are then eliminated from the above mixture, so as to obtain a crude germ fraction (a mixture comprising germ as a main component, crushed albumen fragments, and crushed seed coat fragments. The power applied to a wheat seed may be a power necessary for separating germ from the wheat seed. Specifically, plant seeds are crushed using a known crusher, so as to obtain a mixture comprising germ, crushed albumen fragments, and crushed seed coat fragments.

Wheat seeds can be crushed with a commonly known crusher. Preferred examples of a crusher for applying impact force to a product to be crushed may include a pin mill and a hammer mill. As a crushing degree, a wheat seed is crushed into a size of generally 4 mm or smaller, and preferably 2 mm or smaller in the maximum length. In addition, dry crushing is preferable.

Subsequently, a crude germ fraction is obtained from the thus crushed wheat seed fragments, using a commonly known classifier such as a sieve. In the case of a wheat seed for example, a crude germ fraction with a mesh size between 0.5 mm and 2.0 mm, and preferably 0.7 mm and 1.4 mm, is obtained. Moreover, seed coat fragments, albumen fragments, contaminants, or the like contained in the obtained crude germ fraction may be removed by utilizing wind power or electrostatic power.

Furthermore, such a crude germ fraction can also be obtained by a method utilizing a difference in specific gravity among the germ, the seed coat, and the albumen, such as heavy liquid separation. In order to obtain a crude germ fraction containing a larger amount of germ, it may also be possible to use some of the aforementioned methods in combination. Thereafter, germ is selected from the obtained crude germ fraction by visual observation, the use of a color-sorting machine, or the like.

In some cases, albumen components may be attached to the thus obtained germ fraction. Thus, in general, the germ fraction is preferably further subjected to a washing treatment for purification of the germ. As such a washing treatment, it is preferable that the germ fraction be dispersed and/or suspended in water or an aqueous solution that is cooled to generally 10°C or lower, and preferably 4°C or lower, and that it be washed until the washing solution does not become cloudy. In addition, it is more preferable that the germ fraction be dispersed and/or suspended in an aqueous solution containing a surfactant generally at 10°C or lower, and preferably at 4°C or lower, and that it be washed until the washing solution does not become cloudy. Nonionic surfactants are preferably used as a surfactant. A wide range of surfactants can be used, as long as they are nonionic surfactants. Specifically, preferred examples of such a surfactant may include polyoxyethylene derivatives such as Brij, Triton, Nonidet P40, or Tween. Of these, Nonidet P40 is most suitable. These nonionic surfactants can be used at a concentration of 0.5%, for example. Either the washing treatment with water or an aqueous solution, or the washing treatment with a surfactant, may be carried out. Or, both of these washing treatments may also be carried out. Moreover, these washing treatments may be carried out in combination with ultrasonication.

In the present invention, after wheat germ has been selected from the crush product obtained by crushing wheat seeds as described above and then washed, the obtained intact germ (having germinating capacity) is fragmentated in the presence of an extraction solvent. Thereafter, the obtained wheat germ extract is separated and further purified, so as to obtain a wheat germ extract used for cell-free protein synthesis.

As such an extraction solvent, an aqueous solution containing a buffer solution, potassium ion, magnesium ion, and/or an antioxidant for a thiol group, can be used. In addition, calcium ion, L-amino acids, or the like may also be added thereto, as necessary. For example, a solution containing N-2-hydroxyethylpiperazin-N'-2-ethanesulfonic acid (HEPES)-KOH, potassium acetate, magnesium acetate, L-amino acids, and/or dithiothreitol, or a solution obtained by partially modifying the method of Patterson et al. (a solution containing HEPES-KOH, potassium acetate, magnesium acetate, calcium chloride, L-amino acids, and/or dithiothreitol), can be used as an extraction solvent. The composition of components contained in such an extraction solvent and the concentration thereof have already been known. Solvents used in the production method of a wheat germ extract used for cell-free protein synthesis may be adopted.

Germ is mixed with an extraction solvent that is in an amount necessary for extraction, and the germ is then fragmentated in the presence of the extraction solvent. The amount of such an extraction solvent is generally 0.1 ml or more, preferably 0.5 ml or more, and more preferably 1 ml or more, with respect to 1 g of the germ before being washed. The upper limit of the amount of such an extraction solvent is not particularly limited. It is generally 10 ml or less, and preferably 5 ml or less, with respect to 1 g of the germ before being washed. As germ to be fragmentated, the conventional frozen germ may be used, or unfrozen germ may also be used. However, unfrozen germ is more preferably used.

As a fragmentation method, conventionally known crushing methods, such as trituration, crushing, shock, or cutting, can be adopted. It is particularly preferable to fragmentate germ by shock or cutting. The term "fragmentation by shock or cutting" is used herein to mean that plant germ is disintegrated under conditions in which damage to cell organelle such as cell nucleus, mitochondrion or chloroplast, cell membrane, cell wall, etc. in the plant germ, can be reduced to a minimum extent as compared with conventional trituration or crushing.

Devices or methods applied to fragmentation are not particularly limited, as long as they satisfy the aforementioned conditions. For example, a device equipped with a rapidly spinning cutting tool, such as Waring blender, is preferably used. The number of rotations of such a cutting tool is generally 1,000 rpm or more, and preferably 5,000 rpm or more. Also, it is generally 30,000 rpm or less, and preferably 25,000 rpm or less. The time of rotation of such a cutting tool is generally 5 seconds or more, and preferably 10 seconds or more. The upper limit of such a rotation time is not particularly limited. It is generally 10 minutes or less, and preferably 5 minutes or less. The temperature applied during fragmentation is preferably 10°C or less, at which operations can be performed, and particularly preferably around 4°C.

By fragmentating the germ by shock or cutting, the cell nucleus or cell wall of the germ is not entirely destroyed, but at least a portion thereof remains undestroyed. That is to say, since the cell organelle such as cell nucleus, cell membrane, or cell wall of the germ is not unnecessarily destroyed, impurities contained therein, such as DNA or lipids, are mixed by only a slight extent. Thus, RNA, ribosome or the like necessary for protein synthesis, which are located in the cytoplasm, can efficiently be extracted from the germ at a high purity.

According to such a method, the conventional step of crushing plant germ and a step of mixing the crushed plant germ and an extraction solvent to obtain a wheat germ extract can simultaneously be carried out as a single step. Thus, a wheat germ extract can efficiently be obtained. Hereinafter, the aforementioned method may be referred to as a "blender method" at time.

Subsequently, the obtained wheat germ extract is recovered by centrifugation or the like, and it is then purified by gel filtration or the like, so as to obtain a purified wheat germ extract. Gel filtration can be carried out, for example, using a gel filtration device that has previously been equilibrated with a solution (a solvent containing HEPES-KOH, potassium acetate, magnesium acetate, dithiothreitol, or L-amino acids). The composition of components contained in a gel filtration solution and the concentration thereof have already been known. Those used in the production method of a wheat germ extract used for cell-free protein synthesis may be adopted.

Sometimes, microorganisms, and particularly, spores of filamentous fungi or the like, may be contained in a germ extract-containing solution after the gel filtration. These microorganisms are preferably eliminated. In particular, the proliferation of microorganisms is sometimes observed during a cell-free protein synthesis reaction over a long period of time (1 day or longer). It is important to prevent such proliferation of microorganisms. A means for eliminating microorganisms is not particularly limited. The use of a mechanically sterilized filter is preferable. The pore size of such a filter is not particularly limited, as long as it is able to eliminate microorganisms that are possibly mixed into a germ extract-containing solution. A suitable pore size is generally between 0.1 and 1 µm, and preferably between 0.2 and 0.5 µm. Since the size of a spore of a small type of microorganism, *Bacillus subtilis,* is 0.5 µm x 1 µm, the use of a 0.20-µm filter (for example, Minisart™ manufactured by Sartorius) is effective for elimination of spores. For filtration, it is preferable that a germ extract-containing solution be first filtrated through a filter with a relatively large pore size, and that it be then filtrated through a filter with a pore size capable of eliminating microorganisms that are possibly mixed therein.

From the thus obtained cell extract, albumen containing substances suppressing protein synthetic functions which are possessed or retained by raw material cells (substances such as tritin, thionine, or ribonuclease, which act on mRNA, tRNA, translation protein factors, ribosome, or the like, so as to suppress the functions thereof), has been almost completely removed, and as a result, the cell extract has been purified. A cell extract, from which albumen has been almost completely removed and which has been thereby purified, is used herein to mean a wheat germ extract, from which an albumen portion has been removed to such an extent that ribosome is substantially not deadenylated. Moreover, the passage "such an extent that ribosome is substantially not deadenylated" means that the deadenylation ratio of ribosome is less than 7%, and preferably 1% or less.

As stated above, since such a cell extract contains protein synthesis inhibitory substances with a low molecular weight (hereinafter referred to as "low-molecular-weight synthesis inhibitory substances" at times), the fractions of these low-molecular-weight synthesis inhibitory substances are eliminated from the constitutional components of the cell extract, depending on a difference in molecular weight. It may be adequate that the molecular weight of substances to be eliminated (low-molecular-weight inhibitory substances) be smaller than those of factors necessary for protein synthesis contained in the cell extract. Specifically, the molecular weight is between 50,000 and 14,000, and preferably 14,000 or less.

As a method for eliminating low-molecular-weight synthesis inhibitory substances from a cell extract, commonly used known methods are applied. Specific examples of such a method may include a method involving dialysis using a dialysis membrane, gel filtration, and ultrafiltration. Of these, a method involving dialysis (dialysis method) is preferable in terms of easy supply of substances to an internal dialysis solution. As an example, the case of applying the dialysis method will be described in detail below.

A dialysis membrane used in dialysis has a molecular weight to be eliminated between 50,000 and 12,000. Specifically, a regenerated cellulose membrane with a molecular weight to be eliminated between 12,000 and 14,000 (manufactured by Viskase Sales, Chicago), Spectra/Pore6 with a molecular weight to be eliminated of 50,000 (manufactured by SPECTRUM LABORATORIES INC., CA, U.S.A.), or the like are preferably used. An appropriate amount of the aforementioned cell extract is placed in such a dialysis membrane, and dialysis is carried out by a common method. The time necessary for dialysis is preferably approximately between 30 minutes and 24 hours.

When low-molecular-weight synthesis inhibitory substances are eliminated, if insoluble components are generated in a cell extract, such generation of insoluble components is inhibited (hereinafter referred to as "stabilization of a cell extract" at times). Such inhibition of generation of insoluble components enhances the protein synthetic activity of the finally obtained cell extract (hereinafter referred to as "post-treatment cell extract" at times). A specific example of a method of stabilization of a cell extract may be a method of eliminating the aforementioned low-molecular-weight inhibitory substances in a solution containing at least a high-energy phosphate compound such as ATP or GTP. ATP is preferably used as a high-energy phosphate compound. In addition, elimination of the low-molecular-weight inhibitory substances is carried out in a solution containing preferably ATP and GTP, and more preferably ATP, GTP, and 20 types of amino acids.

When elimination of low-molecular-weight inhibitory substances is carried out in a solution containing these components (hereinafter referred to as "stabilizing components" at times), after such stabilizing components have previously been added to a cell extract and the mixture has been incubated, the resultant may be then subjected to a step of eliminating the low-molecular-weight inhibitory substances. When the dialysis method is applied to eliminate such low-molecular-weight inhibitory substances, stabilizing components are added not only to the cell extract, but also to an external dialysis solution, and thereafter, dialysis is carried out, thereby eliminating the low-molecular-weight inhibitory substances. Such addition of stabilizing components to an external dialysis solution is more preferable because new stabilizing components are constantly supplied although the existing stabilizing components are decomposed during the dialysis. This can also be applied to the case of applying gel filtration or ultrafiltration. Each carrier is equilibrated with a buffer solution for filtration that contains stabilizing components, and a cell extract containing stabilizing components is then added thereto. While the aforementioned buffer solution is added thereto, filtration is carried out, thereby obtaining the same effects.

The additive amount of stabilizing components and the time necessary for such a stabilization treatment can be selected as appropriate, depending on the type of the cell extract or a preparation method thereof. An example of such a selection method may include a method, which comprises tentatively determining the amount and type of stabilizing components, adding the stabilizing substances to a cell extract, eliminating low-molecular-weight inhibitory substances after a certain period of time, and separating the obtained post-treatment cell extract into soluble components and insoluble components by centrifugation or the like, and selecting a portion containing a smaller amount of insoluble components. Further, the obtained post-treatment cell extract is subjected to cell-free protein synthesis, so as to examine whether or not the aforementioned conditions are satisfied. A method of simply selecting those with higher protein synthetic activity from the obtained products is preferable. When a cell extract is used in combination with the dialysis method in the aforementioned selection method, it is also adequate that suitable stabilizing components be added also to an external dialysis solution, that dialysis be carried out using these components for an appropriate period of time, and that selection be then carried out depending on the amount of insoluble components in the obtained cell extract or the protein synthetic activity of the obtained cell extract.

As specific examples of the thus selected conditions for stabilization of the cell extract, when low-molecular-weight inhibitory substances are eliminated from a wheat germ extract prepared by the blender method according to the dialysis method, 100 µM to 0.5 mM ATP, 25 µM to 1 mM GTP, and 20 types of amino acids each having a concentration of 25 µM to 5 mM, are added to the wheat germ extract and an external dialysis solution, and dialysis is then carried out for 30 minutes to 1 hour or longer. Any temperature may be applied during the dialysis, as long as protein synthetic activity is not lost and dialysis can be carried out at the temperature. Specifically, the minimum temperature is a temperature at which a solution does not freeze, and it is generally -10°C, and preferably -5°C. The maximum temperature is 40°C, which is the critical temperature that does not affect a solution used for dialysis, and it is preferably 38°C.

A method of adding stabilizing components to a cell extract is not particularly limited. Such stabilizing components are added to a cell extract before a step of eliminating low-molecular-weight inhibitory substances, and the mixture is then incubated for an appropriate period of time for stabilization. Thereafter, the resultant may be subjected to the step of eliminating low-molecular-weight inhibitory substances. Otherwise, the above step of eliminating low-molecular-weight inhibitory substances may also be carried out using a cell extract to which stabilizing components have been added, and/or a buffer solution used for the above elimination step, to which stabilizing components have been added.

As a wheat germ extract used in the method of the present invention, those containing a small amount of DNA and/or a small amount of total fatty acids (palmitic acid, oleic acid, and linolic acid) are preferable. Preferred examples may include: (a) a wheat germ extract having a DNA content of 230 µg/ml or less, when the optical density (O.D.) at 260 nm (A260) is 90; and (b) a wheat germ extract having a total amount of total fatty acids (palmitic acid, oleic acid, and linolic acid) of 0.03 g or less/100 g, when the optical density (O.D.) at 260 nm (A260) is 90. Further, a wheat germ extract satisfying both conditions (a) and (b) described above is particularly preferable.

The above-described wheat germ extract is placed in a known system or device which is selected, so as to synthesize proteins. Examples of methods applied to such a system or device for synthesizing proteins may include: a protein synthesis method involving the addition of an energy source, amino acids or tRNA necessary for the synthesis of a cell-free protein, to the aforementioned cell extract, such as the batch method (Pratt J. M. et al., Transcription and Translation, Hames, 179-209, B. D. & Higgins S. J., eds, IRL Press, Oxford (1984)); a continuous cell-free protein synthesis system for continuously supplying amino acids, an energy source or the like to a reaction system (Spirin A. S. et al., Science, 242, 1162-1164 (1988)); the dialysis method (Kikawa et al., the 21^{st} Annual Meeting of Molecular Biology Society of Japan, WID6); and the double layer method (an instruction manual included with PROTEIOS™ wheat germ cell-free protein synthesis core kit; manufactured by TOYOBO). In addition, a method which comprises supplying template RNA, amino acids, an energy source or the like to a reaction system as needed, and eliminating synthetics or decomposition products as needed, can also be used (Japanese Patent Application Laid-Open (Kokai) No. 2000-333673; hereinafter referred to as a "discontinuous gel filtration method" at times).

In such a synthesis reaction, the composition of a reaction solution comprises the aforementioned cell extract, a translation template, amino acids acting as substrates, an energy source, various types of ions, a buffer solution, an ATP regenerative system, a nuclease inhibitor, tRNA, a reducing agent, polyethylene glycol, 3',5'-cAMP, folate, an antibacterial agent, etc., for example. When DNA is used as a translation template, a reaction solution further comprises a substrate for RNA synthesis that is necessary for a transcription reaction, RNA polymerase, and so on. These components are appropriately selected and prepared depending on proteins of interest or the type of a protein synthesis system. Such amino acids acting as substrates are 20 types of amino acids constituting a protein, to which markers suitable for NMR analysis described later are added. Specifically, 20 types of amino acids labeled with ¹⁵N (manufactured by Cambridge Isotope Laboratories) are preferable. The concentration of these amino acids is preferably between 0.05 and 0.4 mM. In addition, ATP or GTP is used as an energy source. ATP is preferably added at a concentration between 1.0 and 1.5 mM. GTP is preferably added at a concentration between 0.2 and 0.3 mM. Examples of various types of ions with suitable concentrations in a reaction solution may include: 60 to 120 mM potassium acetate; and 1 to 10 mM magnesium acetate. Examples of a buffer solution used herein may include 15 to 35 mM Hepes-KOH and 10 to 50 mM Tris-acetate. Examples of an ATP regenerative system may include: a combination of phosphoenol pyruvate with pyruvate kinase; or a combination of creatinephosphoric acid (creatine phosphate) with creatine kinase. Examples of a nuclease inhibitor may include: a ribonuclease inhibitor of 0.3 to 3.0 U per µl of a reaction solution; and a nuclease inhibitor of 0.3 to 3 U per µl of a reaction solution.

A specific example of a ribunuclease inhibitor used herein may be human placenta-derived RNase inhibitor (manufactured by TOYOBO). tRNA can be obtained by methods described in Moniter R. et al., Biochim. Biophys. Acta., 43, 1 (1960), etc. Otherwise, commercially available products can also be used. 0.1 to 3.0 mM dithiothreitol is an example of a reducing agent. Examples of an antibacterial agent may include 0.001% to 0.01% sodium azide or 0.1 to 0.2 mg/ml ampicillin. As a nucleic acid stabilizer, 0.3 to 0.5 mM spermidine or the like can be used. Further, as RNA polymerase, those suitable for a promoter contained in a translation template are used. Specific examples of RNA polymerase used herein may include SP6 RNA polymerase and T7 RNA polymerase. The additive amounts of these components are determined as appropriate, so as to prepare a synthesis reaction solution.

Among the aforementioned reaction methods, when the former batch method is applied, if protein synthesis is carried out for a long period of time, the reaction may probably be terminated. Thus, the reaction can be maintained for a long period of time by using the systems of the latter methods for continuously or discontinuously supplying amino acids or an energy source to a reaction system, thereby further promoting efficiency. When a wheat germ extract is prepared by the blender method, it contains tRNA. Accordingly, it is not necessary to add tRNA in this case.

When protein synthesis is carried out by the batch method, the aforementioned synthesis reaction solution, from which a translation template has been eliminated, is pre-incubated for a suitable period of time, as necessary, and a translation template is then added to the reaction solution, followed by incubation, for example. When a wheat germ extract is used, the above pre-incubation is carried out at 10°C to 40°C for 5 to 10 minutes. The above incubation is carried out at 10°C to 40°C, preferably 18°C to 30°C, and more preferably 20°C to 26°C. The reaction time indicates a period of time required until the reaction is terminated. In the batch method, it is generally approximately between 10 minutes and 7 hours.

When protein synthesis is carried out by the dialysis method, a synthesis reaction solution is used as an internal dialysis solution, and using a device wherein the internal dialysis solution is isolated from an external dialysis solution via a dialysis membrane capable of giving passage to substances, protein synthesis is carried out. Specifically, the aforementioned synthesis reaction solution, from which a translation template has been eliminated, is pre-incubated for a suitable period of time, as necessary, and a translation template is then added to the reaction solution, for example. Thereafter, the mixed solution is placed in a suitable dialyzer, and it is used as an internal reaction solution. Examples of such a dialyzer may include: a vessel to the bottom of which a dialysis membrane is attached (dialysis cup 12,000, manufactured by Daiichi Kagaku, etc.); and a dialysis tube (12,000, manufactured by Sanko Junyaku, etc.). As a dialysis membrane, a membrane having a molecular weight limit that is smaller than the molecular weight of a protein to be dialyzed is used. A dialysis membrane having a molecular weight limit between 6,000 and 12,000 daltons is preferable.

As an external dialysis solution, a solution obtained by eliminating a translation template from the aforementioned synthesis reaction solution is used. At the time when a reaction rate decreases, the external dialysis solution is exchanged with a fresh one, so as to increase dialysis efficiency. The reaction temperature and the reaction time are appropriately determined depending on a protein synthesis system used. In the case of a system using a wheat germ extract, the reaction can be carried out generally at 10°C to 40°C, preferably 18°C to 30°C, and more preferably 20°C to 26°C, for 10 minutes to 12 days.

When protein synthesis is carried out by the double layer method, a synthesis reaction solution is placed in a suitable vessel, and the external dialysis solution described in the aforementioned dialysis method is then applied on the above synthesis reaction solution without disturbing the interface thereof, so as to carry out protein synthesis. Specifically, the aforementioned synthesis reaction solution, from which a translation template has been eliminated, is pre-incubated for a suitable period of time, as necessary, and a translation template is then added to the reaction solution, for example. Thereafter, the mixed solution is placed in a suitable vessel, and it is used as a reaction phase. A microtiter plate or the like is used as the above vessel. The external dialysis solution (supply phase) described in the aforementioned dialysis method is applied to the upper layer of the above reaction phase without disturbing the interface thereof, and the reaction is then carried out.

The interface of both phases is not necessarily formed into a horizontal plane by lamination. It is also possible to form a horizontal plane by centrifugation of a mixed solution comprising both phases. When the diameter of the circular interface of both phases is 7 mm, the volume ratio between the reaction phase and the supply phase is generally between 1 : 4 and 1 : 8. It is preferably 1 : 5. As the interface area of both phases increases, a higher substance exchange ratio can be obtained by dispersion, and protein synthesis efficiency thereby increases. Accordingly, the volume ratio of both phases changes depending on the interface area of both phases. A synthesis reaction is carried out under static conditions, and the reaction temperature and the reaction time are appropriately determined depending on a protein synthesis system used. In the case of a system using a wheat germ extract, the reaction can be carried out generally at 10°C to 40°C, preferably 18°C to 30°C, and more preferably 20°C to 26°C, for 10 to 17 hours. In addition, when an *Escherichia coli* extract is used, the reaction temperature is suitably between 30°C and 37°C.

When protein synthesis is carried out by the discontinuous gel filtration method, a synthesis reaction is carried out with a synthesis reaction solution. At the time when the synthesis reaction is terminated, template RNA, amino acids, an energy source, etc. are supplied thereto, and synthesized products and decomposed products are eliminated, so as to carry out protein synthesis. Specifically, the aforementioned synthesis reaction solution, from which a translation template has been eliminated, is pre-incubated for a suitable period of time, as necessary, and a translation template is then added to the reaction solution, for example. Thereafter, the mixed solution is placed in a suitable vessel, and the reaction is then carried out. A microtiter plate or the like is used as the above vessel. Under these conditions, when a reaction solution containing 48% by volume of a wheat germ extract is used for example, the synthesis reaction is completely terminated after the reaction has been carried out for 1 hour. This fact can be confirmed by the measurement of amino acids incorporated into proteins or the polyribosome analysis according to the sucrose density-gradient centrifugation method (Proc. Natl. Acad. Sci. U.S.A., 97, 559-564 (2000)).

The aforementioned reaction solution obtained after termination of the synthesis reaction is passed through a gel filtration column that has previously been equilibrated with a supply solution having the same composition as that of the external dialysis solution described in the aforementioned dialysis method. The filtrated solution is retained at a suitable reaction temperature again, so that a synthesis reaction restarts, and that protein synthesis then progresses over several hours. Thereafter, this reaction and gel filtration are repeated. The reaction temperature and the reaction time are appropriately determined depending on a protein synthesis system used. In the case of a system using a wheat germ extract, it is preferable that gel filtration be repeatedly carried out at 26°C every about 1 hour.

The presence of the thus obtained proteins can be confirmed by known methods. Examples of such a known method may include: the measurement of amino acids incorporated into proteins; separation of proteins by SDS-polyacrylamide electrophoresis and staining with Coomassie brilliant blue (CBB); and autoradiography (Endo Y. et al., J. Biotech., 25, 221-230 (1992); Proc. Natl. Acad. Sci. U.S.A., 97, 559-564 (2000)).

In the case of labeled proteins synthesized by the aforementioned synthesis methods, which satisfy conditions suitable for protein synthesis in the present invention, even though the above labeled proteins are subjected to NMR measurement without being separated and purified from other labeled proteins, noise signals other than signals derived from the proteins of interest are not observed. However, even when synthesis is carried out under conditions suitable for the protein synthesis in the present invention, there are cases where the reaction solution is passed through a gel filtration column for the purpose of exchanging a buffer solution. Such an operation is not included in the step of separating and purifying the proteins of interest from other labeled proteins.

The details of the NMR measurement method will be described below. After proteins have been synthesized under the aforementioned conditions, they are subjected to NMR measurement without a step of separating and purifying them from other labeled proteins. In this measurement, the aforementioned synthesis reaction solution can directly be used. However, it is preferably concentrated to 100 µM or higher by a commonly used known method, and the obtained concentrate is then passed through a gel filtration column that has previously been equilibrated with a buffer solution used for NMR measurement (50 mM sodium phosphate (pH 6.5), 100 mM NaCl, etc.), so as to exchange the buffer solution with another one, thereby preparing a sample used for NMR measurement. As such a gel filtration column, a Micro Spin G-25 gel filtration column (manufactured by Amersham) or the like is preferably used. Even after this step, the above synthesis reaction solution comprises proteins derived from a cell extract, in addition to the synthesized proteins. However, by performing heteronuclear NMR measurement, only signals of the proteins of interest can be obtained.

The NMR measurement method can be carried out by the aforementioned methods. For example, an NMR measurement method called ¹H-¹⁵N HSQC is preferably applied (Cavanagh W. J. et al., Protein NMR Spectroscopy. Principles and Practice, Academic Press (1996)). ¹H-¹⁵N HSQC is a correlation spectrum of a hydrogen atom and a nitrogen atom in a peptide bond in a protein, that is, a ¹H-¹⁵N correlation spectrum. Information regarding each residue can be obtained from ¹H-¹⁵N signals that are derived from a main chain thereof. The NMR measurement method of the present invention enables the analysis of the three-dimensional structure of a target high molecular substance of a protein of interest.

In the thus obtained spectrum, when the number of signals derived from the main chain makes up 80% to 150%, preferably 80% to 130%, and more preferably 80% to 110% of the total number of amino acid residues contained in the protein, it can be identified that the protein contained in a synthesis reaction solution has a regular three-dimensional structure. Moreover, in the obtained spectrum, when a chemical shift of 30% or more of hydrogen atoms of signals derived from the main chain is out of the range between 8.0 and 8.5 ppm, it can be identified that the protein contained in a synthesis reaction solution has a regular three-dimensional structure. Furthermore, in the obtained spectrum, when the number of signals derived from the main chain makes up 80% to 100% or less of the total number of amino acid residues contained in the protein, it can be identified that the folding of the synthesized protein is a single three-dimensional structure.

When the synthesized protein has been identified as having a single regular three-dimensional structure, it can be determined that the protein synthesized by a certain method is suitable as a sample, the three-dimensional structure of which is specified by NMR measurement. That is to say, it can be considered that the synthesized protein has the same three-dimensional structure as that of a protein of interest existing in a living body. In addition, it can also be determined that the protein synthesized by this method is suitable as a sample, which is crystallized by the combined use of known methods and then analyzed with X-ray, so as to specify the three-dimensional structure thereof. In contrast, when the obtained spectrum is out of the aforementioned ranges, it can be determined that the synthesized protein is not suitable as a sample used for analyzing the three-dimensional structure thereof.

### EXAMPLES

The present invention will be more specifically described below in the following examples. However, these examples are provided for illustrative purposes only, and are not intended to limit the scope of the present invention.

### Example 1: Preparation of wheat germ extract

Chihoku wheat seeds (unsterilized) produced in Hokkaido were added to a mill (Rotor Speed Mill pulverisette type 14, manufactured by Fritsch) at a rate of 100 g/l minute. The seeds were then gently crushed at a rotation number of 7,000 rpm. This crushing treatment was repeated 4 times. Fractions containing germ having germinating capacity were recovered using a sieve (a mesh size between 0.71 mm and 1.00 mm), and they were then subjected to heavy liquid separation using a mixed solution consisting of carbon tetrachloride and cyclohexane [carbon tetrachloride : cyclohexane = 2.4 : 1 (volume ratio)], so as to recover floating fractions containing germ having germinating capacity. Thereafter, the organic solvents were removed by drying at room temperature, and then, impurities such as seed coats mixed into the resultant were removed by air blasting at room temperature, so as to obtain a crude germ fraction.

Subsequently, using a belt color-sorting machine BLM-300K (manufacturer: Anzai MFG Co., Ltd.; selling agency: Anzai Sogyo, Ltd.), germ was separated from the crude germ fraction utilizing a difference in color, as described below. This color-sorting machine is a device, which comprises a means of applying light to the crude germ fraction, a means for detecting reflected light and/or transmitted light from the crude germ fraction, a means for comparing a detection value with a reference value, and a means for selecting and eliminating those out of or within the reference value.

The crude germ fraction was supplied onto a beige belt of the color-sorting machine, resulting in an amount of 1,000 to 5,000 grains/m². Light was applied from a fluorescent light to the crude germ fraction on the beige belt of the color-sorting machine, so as to detect reflected light. The rate of transferring the belt was set at 50 m/minute. As a photoreceiver, a monochrome CCD line sensor (2,048 pixes) was used.

First, in order to eliminate black components (seed coats, etc.) from germ, the beige belt was mounted on the machine, and a reference value was set between the luminance of the germ and that of the seed coats. Those that were out of the reference value were removed by aspiration. Subsequently, in order to separate albumen, the belt was exchanged with a deep green belt, and a reference value was then set between the luminance of the germ and that of the albumen. Thereafter, those out of the reference value were removed by aspiration. Such aspiration was carried out using 30 aspiration nozzles established at about 1 cm above the transferring belt (the aspiration nozzles were placed at intervals of 1 cm).

Germ was selected by repeatedly performing this operation, until the purity of the germ (the weight ratio of the germ contained in 1 g of any given sample) became 98% or more.

50 g of the wheat germ obtained as described above was suspended in distilled water at 4°C, and the suspension was then washed using an ultrasonic washer, until the washing solution did not become cloudy. Subsequently, the resultant solution was suspended in a solution containing 0.5% by volume of Nonidet P40, and the obtained suspension was then washed using an ultrasonic washer, until the washing solution did not become cloudy, so as to obtain wheat germ from which an albumen portion had been eliminated.

Subsequently, the following operation was carried out at 4°C, so as to obtain a germ extract-containing solution. First, the washed wheat germ and 100 ml of an extraction solvent (80 mM HEPES-KOH (pH 7.6), 200 mM potassium acetate, 2 mM magnesium acetate, 4 mM calcium chloride, 20 types of L-amino acids (each 0.6 mM), and 8 mM dithiothreitol) were placed in a Waring blender. The mixture was crushed at a rotation number between 5,000 and 20,000 rpm for 30 seconds. Germ or the like attached to the inner wall of the blender were scraped off, and the above operation of crushing the mixture at a rotation number between 5,000 and 20,000 rpm for 30 seconds was performed twice again. The particle size distribution of the crushed germ product was measured using a laser scattering particle size distribution analyzer (LA-920, manufactured by Horiba, Ltd.).

The obtained mixture consisting of an extract and crushed germ was transferred into a centrifuge tube, and it was then centrifuged at 30,000 g for 30 minutes, so as to collect a supernatant. The operation of centrifuging the obtained supernatant at 30,000 for 30 minutes was repeatedly performed 5 times, so as to obtain a supernatant with no turbidity. Thereafter, the obtained supernatant was subjected to gel filtration using a Sephadex G-25 column that had previously been equilibrated with a solution (40 mM HEPES-KOH (pH 7.6), 100 mM potassium acetate, 5 mM magnesium acetate, 20 types of L-amino acids (each 0.3 mM), and 4 mM dithiothreitol). The obtained solution was centrifuged at 30,000 g for 12 minutes, so as to collect a supernatant. The obtained supernatant was defined as a wheat germ extract-containing solution. The concentration of a sample was adjusted with an extraction solvent, such that the optical density (O.D.) at 260 nm (A260) became 80 to 150 (A260/A280 = 1.5).

### Example 2: NMR analysis of yeast ubiquitin protein

### (1) Synthesis of mRNA

The yeast ubiquitin gene (Genbank accession No. X01474) was amplified by the PCR method, using, as a template, yeast genomic DNA prepared from the *Saccharomyces cerevisiae* strain according to the Hereford method (Hereford L. et al., Cell, 18, 1261-1271 (1973)), and also using primers having the nucleotide sequences shown in SEQ ID NOS: 1 and 2. The amplified product was then introduced into the *Spe*I*-Sal*I site of a plasmid pEU3b (WO01/27260). Yeast ubiquitin mRNA was transcribed and synthesized using SP6 RNA polymerase (manufactured by Promega), using the above plasmid as a template, in the presence of 16 mM magnesium ions.

### (2) Synthesis of yeast ubiquitin protein using wheat germ extract

The mRNA synthesized in (1) above was concentrated into 100 µg/130 µl, and the concentrate was then mixed with a wheat germ extract (Proteios™, manufactured by TOYOBO) (1 ml). The mixed solution was reacted with a dialysis buffer solution containing 20 types of amino acids labeled with ¹⁵N (manufactured by Cambridge Isotope Laboratories) for 2 days. Thereafter, the dialysis buffer solution was exchanged with a fresh one, and the above protein synthesis reaction was further carried out for 2 days. 1 ml of the reaction solution was concentrated to 250 µl using a Centricon-3 ultrafiltration concentration device manufactured by Millipore. The concentration of the yeast ubiquitin protein contained in this concentrate became 120 µM. The concentrate was passed through a Micro Spin G-25 gel filtration column manufactured by Amersham that had previously been equilibrated with a buffer solution used for NMR measurement (50 mM sodium phosphate (pH 6.5) and 100 mM NaCl), so as to exchange the buffer solution with another one, thereby preparing an NMR measurement sample.

### (3) Protein synthesis using living cells of Escherichia coli and a cell-free protein synthesis system derived from Escherichia coli

The yeast ubiquitin gene DNA amplified in (1) above was introduced into the *Nde*I*-Sal*I site of a plasmid pET24a (manufactured by Novagen). Using the thus produced plasmid as a template, a yeast ubiquitin protein was synthesized with ¹⁵N-labeled ammonium chloride (manufactured by Isotec) in accordance with the method of Sakamoto et al. (Sakamoto T. et al., 1999, Biochemistry, 38, 11634-11642), using living cells of *Escherichia coli* (BL21(DE3) strain; manufactured by Novagen). The obtained protein was purified using an SP sepharose FF column. At the same time, the yeast ubiquitin gene DNA amplified in (1) above was introduced into the *Nde*I*-Sal*I site of a plasmid pIVEX2.3-MCS (manufactured by Roche). Using the thus produced plasmid as a template, a yeast ubiquitin protein was synthesized using 20 types of amino acids labeled with ¹⁵N (manufactured by Cambridge Isotope Laboratories), employing an RTS500 *E. coli* HY kit (manufactured by Roche) in accordance with the method described in the manual included with the kit.

### (4) NMR measurement

For NMR measurement, using an Avance-500 spectrometer manufactured by Bruker, 10% D₂O was added to a measurement sample for NMR lock, so as to maintain the stability of the magnetic field. Then, ¹H-¹⁵N HSQC was measured. The measurement temperature was set at 30°C.

### (5) Results

¹⁵N-labeled yeast ubiquitin was synthesized using a wheat germ cell-free protein synthesis system. The obtained yeast ubiquitin was concentrated, and the buffer solution was then exchanged with another one. Thereafter, ¹H-¹⁵N HSQC was measured. The results are shown in Figure 1. Moreover, ¹⁵N-labeled yeast ubiquitin was synthesized using living cells of *Escherichia coli,* and it was then purified (it was confirmed that this yeast ubiquitin had a correct three-dimensional structure and functions). The results obtained by the measurement of the ¹H-¹⁵N HSQC spectrum thereof are shown in Figure 2. As is clear from these figures, when NMR was measured without purification of the sample obtained using a wheat germ cell-free protein synthesis system, the above sample had completely the same spectrum as that of the sample synthesized using *Escherichia coli* and then purified. On the other hand, ¹⁵N-labeled yeast ubiquitin was synthesized using a cell extract of *Escherichia coli,* and it was then concentrated without being purified. The buffer solution was exchanged with another one, and the ¹H-¹⁵N HSQC spectrum thereof was measured. The results are shown in Figure 3. In the figure, the spectrum enclosed with a circle means a signal derived from impurities. Such signals were observed in the sample synthesized using a cell extract of *Escherichia coli,* and no such signals were observed in the sample synthesized using a wheat germ cell-free protein synthesis system. Accordingly, it was found that even when the proteins synthesized with a wheat germ cell-free protein synthesis system were labeled without being purified, only proteins of interest were labeled, and that such proteins of interest had a correct three-dimensional structure.

Moreover, with regard to this HSQC spectrum, when the sample was incubated at 30°C for 4 days and the same measurement was then carried out again, completely the same spectrum was obtained. Accordingly, it was found that the 15N-labeled proteins synthesized using a wheat germ cell-free protein synthesis system are stably present without being decomposed for a period of time that is sufficient for the measurement.

### Example 3: NMR analysis of yeast ubiquitin hydrolase 1 protein

### (1) Synthesis ofmRNA

The yeast ubiquitin hydrolase 1 gene (Genbank accession No. NC_001142) was amplified by the PCR method, using, as a template, the yeast genomic DNA prepared by the same method as described in Example 2(1) above, and also using primers having the nucleotide sequences shown in SEQ ID NOS: 3 and 4. The thus amplified DNA was mixed with DNA amplified by the PCR method using the same above template and primers having the nucleotide sequences shown in SEQ ID NOS: 5 and 6. Thereafter, DNA was amplified using the thus mixed DNA as a template and also using primers having the nucleotide sequences shown in SEQ ID NOS: 3 and 6. The thus obtained DNA was then introduced into the *Spe*I*-Sal*I site of a plasmid pEU3b (WO01/27260). Yeast ubiquitin hydrolase 1 mRNA was transcribed and synthesized using SP6 RNA polymerase (manufactured by Promega), using the above plasmid as a template, in the presence of 16 mM magnesium ions.

### (2) Synthesis of yeast ubiquitin hydrolase 1 protein and NMR analysis

The mRNA synthesized in (1) above was concentrated into 100 µg/130 µl, and the concentrate was then mixed with a wheat germ extract, then ubiquitin hydrolase 1 was synthesized by the same method as described in Example 2(1). The ubiquitin hydrolase 1 was also synthesized with living cells of *Escherichia coli,* and a cell extract of *Escherichia coli* by the same method as described in Example 2(2) and (3).

The yeast ubiquitin hydrolase 1 proteins synthesized using the wheat germ extract and the cell extract of *Escherichia coli* were concentrated, and the buffer solutions were exchanged with buffer solutions used for NMR analysis. Thereafter, these proteins were subjected to NMR analysis by the same method as described in Example 2(4). On the other hand, the yeast ubiquitin hydrolase 1 protein synthesized using the living cells of *Escherichia coli* was purified using an SP sepharose FF column, and it was then subjected to NMR analysis by the same method as described in Example 2(4).

### (3) Results

A ¹⁵N-labeled yeast ubiquitin hydrolase 1 protein was synthesized using a wheat germ cell-free protein synthesis system. The obtained protein was concentrated, and the buffer solution was then exchanged with another one. Thereafter, the ¹H-¹⁵N HSQC spectrum thereof was measured. The results are shown in Figure 4. On the other hand, ¹⁵N-labeled yeast ubiquitin hydrolase 1 was synthesized using living cells of *Escherichia coli*, and it was then purified (it was confirmed that this yeast ubiquitin hydrolase 1 had a correct three-dimensional structure and functions). The results obtained by the measurement of the ¹H-¹⁵N HSQC spectrum thereof are shown in Figure 5. As is clear from these figures, when NMR was measured without purification of the sample obtained using a wheat germ cell-free protein synthesis system, the above sample had completely the same spectrum as that of the sample synthesized using *Escherichia coli* and then purified. Moreover, a ¹⁵N-labeled yeast ubiquitin hydrolase 1 protein was synthesized using a cell extract of *Escherichia coli*, and it was then concentrated without being purified. The buffer solution was exchanged with another one, and the ¹H-¹⁵N HSQC spectrum thereof was measured. The results are shown in Figure 6. In the figure, the spectrum enclosed with a circle means a signal derived from impurities. As in the case of the aforementioned measurement of a yeast ubiquitin protein, such signals were observed in the sample synthesized using a cell extract of *Escherichia coli,* and no such signals were observed in the sample synthesized using a wheat germ cell-free protein synthesis system.

### Example 4: NMR analysis of Escherichia coli thioredoxin protein

### (1) Synthesis of mRNA

The *Escherichia coli* thioredoxin gene (Genbank accession No. M54881) was amplified by the PCR method, using, as a template, *Escherichia coli* genomic DNA prepared from the *Escherichia coli* K-12 strain using MagPrep Bacterial Genomic DNA Kit (manufactured by Novagen), and also using primers having the nucleotide sequences shown in SEQ ID NOS: 7 and 8. The thus amplified DNA was introduced into the *Spe*I*-Sal*I site of a plasmid pEU3b (WO01/27260; Sawasaki T. et al., Proc. Natl. Acad. Sci. U.S.A., 99(23), 14652-14657 (2002)). *Escherichia coli* thioredoxin mRNA was transcribed and synthesized using SP6 RNA polymerase (manufactured by Promega), using the above plasmid as a template, in the presence of 16 mM magnesium ions.

### (2) Synthesis of Escherichia coli thioredoxin protein and NMR analysis

The mRNA synthesized in (1) above was concentrated into 100 µg/130 µl, and the concentrate was then mixed with a wheat germ extract and a cell extract of *Escherichia coli* by the same method as described in Example 2(2) and (3), so as to synthesize *Escherichia coli* thioredoxin proteins.

The *Escherichia coli* thioredoxin proteins synthesized using the wheat germ extract and the cell extract of *Escherichia coli* were concentrated, and the buffer solutions were exchanged with buffer solutions used for NMR analysis. Thereafter, these proteins were subjected to NMR analysis by the same method as described in Example 2(4).

### (3) Results

A ¹⁵N-labeled *Escherichia coli* thioredoxin protein was synthesized using a wheat germ cell-free protein synthesis system. The obtained protein was concentrated, and the buffer solution was then exchanged with another one. Thereafter, the ¹H-¹⁵N HSQC spectrum thereof was measured. The results are shown in Figure 7. On the other hand, a ¹⁵N-labeled *Escherichia coli* thioredoxin protein was synthesized using a cell extract of *Escherichia coli,* and it was then concentrated without being purified. The buffer solution was exchanged with another one, and the ¹H-¹⁵N HSQC spectrum thereof was measured. The results are shown in Figure 8. In the figure, the spectrum enclosed with a circle means a signal derived from impurities. As in the case of the aforementioned measurement of a yeast ubiquitin protein, such signals were observed in the sample synthesized using a cell extract of *Escherichia coli,* and no such signals were observed in the sample synthesized using a wheat germ cell-free protein synthesis system.

### Example 5: Identification of folding of protein by NMR measurement

### (1) Synthesis of mRNA

A region encoding amino acids from positions 1 to 147 of the human mcm4 gene (Genbank accession No. XM_030273) (hereinafter referred to as a "human mcm4 gene" at times) was amplified by the PCR method, using, as a template, QuickClone cDNA (manufactured by Clontech), and also using primers having the nucleotide sequences shown in SEQ ID NOS: 9 and 10. On the other hand, the *Escherichia coli* thioredoxin gene (Genbank accession No. M54881) was amplified by the PCR method, using, as a template, *Escherichia coli* genomic DNA prepared from the *Escherichia coli* K-12 strain using MagPrep Bacterial Genomic DNA Kit (manufactured by Novagen), and also using primers having the nucleotide sequences shown in SEQ ID NOS: 7 and 8. Each of these DNA was introduced into the *Spe*I*-Sal*I site of a plasmid pEU3b (WO01/27260; Sawasaki T. et al., Proc. Natl. Acad. Sci. U.S.A., 99(23), 14652-14657 (2002)). Human mcm4 mRNA and *Escherichia coli* thioredoxin mRNA were transcribed and synthesized using SP6 RNA polymerase (manufactured by Promega), using the above plasmid as a template, in the presence of 16 mM magnesium ions.

### (2) Protein synthesis and NMR analysis

Each of the mRNA synthesized in (1) above was concentrated into 100 µg/130 µl, and a human mcm4 protein (amino acids from positions 1 to 147) and an *Escherichia coli* thioredoxin protein were then synthesized using a wheat germ extract by the same method as described in Example 2(2) and (3). The synthesized proteins were concentrated, and the buffer solutions were exchanged with buffer solutions used for NMR analysis. Thereafter, NMR analysis was carried out by the same method as described in Example 2(4).

### (3) Results

A ¹⁵N-labeled *Escherichia coli* thioredoxin protein was synthesized using a wheat germ cell-free protein synthesis system. The obtained protein was concentrated, and the buffer solution was then exchanged with another one. Thereafter, the ¹H-¹⁵N HSQC spectrum thereof was measured. The results are shown in Figure 9. On the other hand, a ¹⁵N-labeled human mcm4 protein was synthesized using a wheat germ cell-free protein synthesis system, and it was then concentrated. The buffer solution was exchanged with another one, and the ¹H-¹⁵N HSQC spectrum thereof was measured. The results are shown in Figure 10. In the case of the NMR signals shown in Figure 9, a chemical shift of 30% or more of hydrogen atoms contained in signals derived from the main chain is out of the range between 8.0 and 8.5 ppm. In contrast, in the case of the NMR signals shown in Figure 10, such chemical shifts are within the above range. From these results, it could be identified that the *Escherichia coli* thioredoxin protein synthesized by the aforementioned protein synthesis method has a regular three-dimensional structure, and that the human mcm4 protein does not have such a regular three-dimensional structure.

### INDUSTRIAL APPLICABILITY

The method of the present invention enables NMR measurement without separating and purifying a protein of interest from other labeled proteins, after protein synthesis. Using the method for identifying the folding of a protein by the NMR measurement, it can be determined whether or not a protein of interest synthesized by the method of the present invention can be a suitable sample for specifying the three-dimensional structure thereof by NMR analysis, or by X-ray analysis performed after crystallization of the above protein by the combined use of known methods. Accordingly, the method of the present invention enables high-throughput evaluation of the three-dimensional structure of a protein and the analysis of protein interaction.

The present application is based on a Japanese patent application (Japanese Patent Application No. 2003-32381) filed on February 10, 2003, and the contents of which are hereby incorporated by reference. In addition, all publications cited in the present specification are incorporated herein by reference in their entirety.

## Claims

1. A method for analyzing proteins, which comprises: synthesizing a protein of interest under conditions in which 90% or more of the synthesized labeled proteins constitute the protein of interest, when proteins are synthesized using a nucleic acid encoding the protein of interest as a template and also using substrate amino acids, a part or all of which have been labeled in such a way that NMR measurement is possible; and performing the NMR measurement using the above-described labeled proteins.

2. The method of claim 1 wherein the method for synthesizing the protein of interest is a method using a cell-free protein synthesis system derived from a wheat germ extract, wherein a step of separating the protein of interest from the synthesized labeled proteins is not performed.

3. The method of claim 1 or 2 wherein among substrate amino acids used, 3 or more types of amino acids are labeled in such a way that NMR measurement is possible.

4. The method of claim 2 or 3 wherein the wheat germ extract is extracted from the wheat germ that has been separated such that it does not contain albumen.

5. The method of claim 2 or 3 wherein the wheat germ extract has a DNA content of 230 µg/ml or less, when the optical density (O.D.) at 260 nm (A260) is 90.

6. The method of claim 2 or 3 wherein the wheat germ extract has a total amount of total fatty acids (palmitic acid, oleic acid, and linolic acid) of 0.03 g or less/100 g, when the optical density (O.D.) at 260 nm (A260) is 90.

7. The method of claim 2 or 3 wherein the wheat germ extract has a DNA content of 230 µg/ml or less and a total amount of total fatty acids of 0.03 g or less/100 g, when the optical density (O.D.) at 260 nm (A260) is 90.

8. The method of any of claims 1 to 7 wherein the method for analyzing a protein is a method for identifying the folding of a protein.

9. The method of claim 8 wherein the method for identifying the folding of a protein is a method for determining that a synthesized protein has a regular three-dimensional structure.

10. The method of claim 9 wherein the method for identifying whether or not a protein has a regular three-dimensional structure is a method for determining that a protein has a regular three-dimensional structure, when the number of signals derived from a main chain in the spectrum obtained by NMR measurement makes up 80% or more of the total number of labeled amino acid residues of the above protein.

11. The method of claim 9 wherein the method for identifying whether or not a protein has a regular three-dimensional structure is a method for determining that a protein has a regular three-dimensional structure, when chemical shifts of 30% or more of hydrogen atoms of signals derived from a main chain in the spectrum obtained by NMR measurement is out of the range between 8.0 and 8.5 ppm.

12. The method of claim 8 wherein the method for identifying the folding of a protein is a method for identifying whether or not a protein has a single three-dimensional structure.

13. The method of claim 8 wherein the method for identifying the folding of a protein is a method for identifying whether or not a protein has a single regular three-dimensional structure.

14. The method of claim 13 wherein the method for identifying whether or not a protein has a single regular three-dimensional structure is a method for determining that a protein has a single regular three-dimensional structure, when the number of signals derived from a main chain of the spectrum obtained by NMR measurement makes up 80% to 100% or less of the total number of labeled amino acid residues of the above protein.
